# EUROPÄISCHE PATENTANMELDUNG

(11) **EP 1 885 060 A2**
(43) Veröffentlichungstag der Anmeldung: **06.02.2008**
(21) Anmeldenummer: 07111848.3
(22) Anmeldetag: 05.07.2007
(51) Int. Cl.: H03F 3/217

(54) **Verstärker für einen Radiofrequenzsender zum Übertragen eines Sendesignals an eine otologische Vorrichtung**

(30) Priorität: 28.07.2006 DE 102006035006
(71) Anmelder: Siemens Audiologische Technik GmbH, 91058 Erlangen (DE)
(72) Erfinder: Boguslavskij, Mihail, 96450 Coburg (DE); Reithinger, Jürgen, 91077 Neunkirchen am Brand (DE)
(74) Vertreter: Maier, Daniel Oliver

(57) **Zusammenfassung**

Die Erfindung betrifft einen Verstärker für ein Radiofrequenzsignal zum Übertragen eines Sendesignals an eine otologische Vorrichtung.

Der Verstärker weist wenigstens einen Leistungstransistor (T) zum Schalten eines Ausgangssignals auf. Eine Schaltstrecke des Leistungstransistors ist mit einem Netzwerk derart wirkverbunden, dass eine im Leistungstransistor umgesetzte Verlustleistung mindestens während eines Umschaltens in einen durchgeschalteten Zustand und/oder mindestens während eines Umschaltens in einen gesperrten Zustand wenigstens teilweise reduziert ist.

Die Schaltstrecke des wenigstens einen Transistors ist in Serie über eine Drosselspule (L_Ch) mindestens mittelbar mit einer Versorgungsspannungsquelle (13) verbunden. Der Verstärker weist eine Sendespule (L_S1) als Ausgangslast auf, wobei die Sendespule eine Induktivität aufweist und mit dem Leistungstransistor wirkverbunden ist. Die Sendespule ist mit der Drosselspule transformatorisch gekoppelt, wobei die Drosselspule so eine Ausgangsleistung auf die Sendespule übertragen kann. Die Sendspule kann aus der Ausgangsleistung ein Sendesignal erzeugen.

## Beschreibung

Die Erfindung betrifft einen Verstärker für ein Radiofrequenzsignal zum Übertragen eines Sendesignals an eine otologische Vorrichtung, insbesondere einen Klasse-E-Verstärker. Eine otologische Vorrichtung kann eine Hörhilfe oder ein Tinnitusmasker sein.

Bei einem Sende-Empfangssystem für eine Kommunikation zwischen einer otologischen Vorrichtung und einem Zubehörteil für eine otologische Vorrichtung, beispielsweise eine Fernbedienung oder ein Programmiergerät, kann ein Übertragen von Daten auf induktive Weise erfolgen.

Ein Sender hat in diesem Fall die Aufgabe, eine zugeführte elektrische Energie möglichst effizient in eine Energie eines magnetischen Wechselfeldes umzusetzen. Eine weitere Anforderung an ein solches Sendesystem ist außerdem eine Bandbreite, welche ein Übertragen von Daten mit einer vorbestimmten Datenrate ermöglicht.

Bei digitalen Sende-Empfangssystemen, welche mit komplexen Modulationsverfahren arbeiten, beispielsweise mit einem PSK-Verfahren, einem BPSK-Verfahren oder einem QPSK-Verfahren (PSK = Phase Key Shifting, BPSK = Binary Phase Key Shifting, QPSK = Quad Phase Key Shifting) besteht darüber hinaus die Anforderung an einen solchen Sender eines Sendesystems, dass ein schneller Phasenwechsel möglich ist. In linearen Systemen ist eine Zeit, welche für einen Phasenwechsel benötigt wird, umgekehrt proportional abhängig von einer Bandbreite eines Sendesystems.

Aus der US 6,861,811 B2 ist ein Schaltkreis zum Zünden von elektrodenlosen Gasentladungslampen bekannt. Der Schaltkreis weist einen Halb-Brückengleichrichter mit zwei Schaltelementen auf, welche jeweils eine Emitterelektrode und eine Kontrollelektrode aufweisen. Die vorbezeichnete Schaltelemente sind alternierend schaltbar mittels eines Resonanzregelkreises. Der Resonanzregelkreis ist mit einem Klasse-E-Treiber verbunden, wobei der Klasse-E-Treiber ausgangsseitig transformatorisch mit Gate-Anschlüssen der zwei Schaltelemente gekoppelt ist.

Der Erfindung liegt die Aufgabe zugrunde, einen Verstärker für ein Radiofrequenzsignal anzugeben, welcher die vorgenannten Probleme, insbesondere ein träges Phasenverhalten nicht aufweist.

Diese Aufgabe wird durch einen Verstärker für ein Radiofrequenzsignal zum Übertragen eines Sendesignals an eine otologische Vorrichtung, insbesondere einen Klasse-E-Verstärker gelöst. Eine otologische Vorrichtung kann beispielsweise eine Hörhilfe oder ein Tinnitusmasker sein.

Der Verstärker weist wenigstens einen Leistungstransistor zum Schalten eines Ausgangssignals auf. Eine Schaltstrecke des Leistungstransistors ist mit einem Netzwerk derart wirkverbunden, dass eine im Leistungstransistor umgesetzte Verlustleistung mindestens während eines Umschaltens in einen durchgeschalteten Zustand und/oder mindestens während eines Umschaltens in einen gesperrten Zustands wenigstens teilweise reduziert ist.

Bevorzugt ist die im Leistungstransistor umgesetzte Verlustleistung während eines durchgeschalteten Zustands und/oder eines gesperrten Zustands wenigstens teilweise reduziert. Bevorzugt ist die im Leistungstransistor umgesetzte Verlustleistung um mindestens 30 Prozent, weiter bevorzugt um mindestens 50 Prozent, besonders bevorzugt um mindestens 60 Prozent reduziert.

Die Schaltstrecke des wenigstens einen Transistors ist in Serie über eine Drosselspule mindestens mittelbar mit einer Versorgungsspannungsquelle verbunden. Der Verstärker weist eine Sendespule als Ausgangslast auf, wobei die Sendespule eine Induktivität aufweist und mit dem Leistungstransistor wirkverbunden ist. Die Sendespule ist mit der Drosselspule transformatorisch, insbesondere kernlos transformatorisch oder kerngebunden transformatorisch gekoppelt, wobei die Drosselspule mittels eines koppelnden Magnetfeldes eine Ausgangsleistung auf die Sendespule übertragen kann. Die Sendspule kann aus der Ausgangsleistung ein Sendesignal erzeugen. Ein Kopplungskern eines so gebildeten Transformators ist bevorzugt ein ferromagnetischer Kern, weiter bevorzugt ein Ferritkern.

Ein mittels des koppelnden Magnetfeldes erzielter Kopplungsfaktor der transformatorischen Kopplung liegt bevorzugt kleiner als 1, beispielsweise in einem Bereich zwischen 0,2 und 0,95, weiter bevorzugt zwischen 0,4 und 0,8. Durch einen Kopplungsfaktor von kleiner als 1 wird vorteilhaft ein sinusförmiger Verlauf der in der Sendespule induzierten Spannung erreicht. In der Drosselspule erzeugte Oberwellen können so vorteilhaft unterdrückt werden.

Durch diese Schaltungsanordnung wird vorteilhaft ein schnelles Phasenverhalten erreicht, insbesondere durch ein Rückführen von Energie in die Energiequelle und nichtlineare Eigenschaften im Falle eines ferromagnetischen Kerns der Drosselspule.

In einer bevorzugten Ausführungsform ist die Sendespule von dem Verstärker vorteilhaft galvanisch getrennt. Dies wird insbesondere durch ein galvanisch getrenntes transformatorisches Koppeln erreicht.

In einer vorteilhaften Ausführungsvariante ist die Sendespule mit einer Abstimmimpedanz wirkverbunden. Die Abstimmimpedanz weist bevorzugt einen Kondensator und/oder einen ohmschen Widerstand auf.

In einer weiter bevorzugten Ausführungsvariante ist die Sendespule mit einer Antenne oder einem Anschluss für eine Antenne verbunden. Dadurch kann eine Sendeenergie, welche in der Sendespule umgesetzt wird, über die Antenne abgestrahlt werden.

In einer bevorzugten Ausführungsvariante ist die Ausgangsleistung des Radiofrequenzverstärkers wenigstens teilweise durch ein Windungsverhältnis bestimmt, gebildet aus einer Windungsanzahl von Windungen der Drosselspule und aus einer Windungsanzahl von Windungen der Sendespule.
Auf diese Weise kann vorteilhaft eine Ausgangsleistung des so gebildeten Senders eingestellt werden.

In einer bevorzugten Ausführungsform ist die Drosselspule zusätzlich mit einem ohmschen Vorwiderstand in Serie geschaltet, so dass eine Ausgangsleistung des Verstärkers wenigstens teilweise von dem Vorwiderstand abhängig ist. Auf diese Weise kann vorteilhaft eine Ausgangsleistung des mittels des Verstärkers gebildeten Senders eingestellt werden.

In einer bevorzugten Ausführungsform ist der Verstärker ein Sendeverstärker für einen Radiofrequenzsender einer otologischen Vorrichtung. Eine otologische Vorrichtung kann mit einem solchen Verstärker auf effiziente Weise ein Sendesignal zum Kommunizieren mit einer anderen otologischen Vorrichtung - beispielsweise für ein anderes Ohr eines Benutzers- erzeugen.

Weiter vorteilhaft kann ein solcher Radiofrequenzsender Bestandteil einer Programmiervorrichtung oder eines Zubehörteils für eine otologische Vorrichtung sein. Die Programmiervorrichtung zum Programmieren einer otologischen Vorrichtung ist ausgebildet, Daten über ein Sendesystem mit dem vorbezeichneten Verstärker an eine otologische Vorrichtung zu übertragen.

Eine beispielhafte Hörhilfe mit dem vorab beschriebenen Verstärker oder zum Verbinden mit dem vorab beschriebenen Verstärker weist wenigstens einen Schallempfänger und einen Schallerzeuger auf. Die Schallempfänger sind jeweils ausgebildet, Schallwellen zu empfangen und ein Mikrophonsignal zu erzeugen, welches die jeweils empfangenen Schallwellen repräsentiert.

Der Schallerzeuger ist ausgebildet, einen Schall in Abhängigkeit von einem eingangsseitig empfangenen Leistungssignal zu erzeugen, welcher dem Leistungssignal entspricht.

Die beispielhafte Hörhilfe weist auch eine Übertragungseinheit auf, welche eingangsseitig jeweils mit den Schallempfängern und ausgangsseitig mit dem Schallerzeuger verbunden ist. Die Übertragungseinheit ist ausgebildet, in Abhängigkeit von mindestens einem eingangsseitig empfangenen Mikrophonsignal ein Leistungssignal zu erzeugen, welches wenigstens teilweise das mindestens eine Mikrophonsignal repräsentiert.

Weitere vorteilhafte Ausführungsvarianten ergeben sich aus den in den abhängigen Ansprüchen genannten Merkmalen oder einer Kombination aus diesen.

Die Erfindung wird nun im Folgenden anhand von Figuren und weiteren Ausführungsbeispielen erläutert.
- Figur 1: zeigt ein Ausführungsbeispiel für einen konventionellen Klasse-E-Verstärker;
- Figur 2: zeigt eine Phasensprungantwort eines in Figur 1 dargestellten konventionellen Klasse- E-Verstärkers;
- Figur 3: zeigt ein Ausführungsbeispiel für einen erfindungsgemäßen Klasse-E-Verstärker;
- Figur 4: zeigt eine Phasensprungantwort des in Figur 3 dargestellten erfindungsgemäßen Klasse-E-Verstärkers

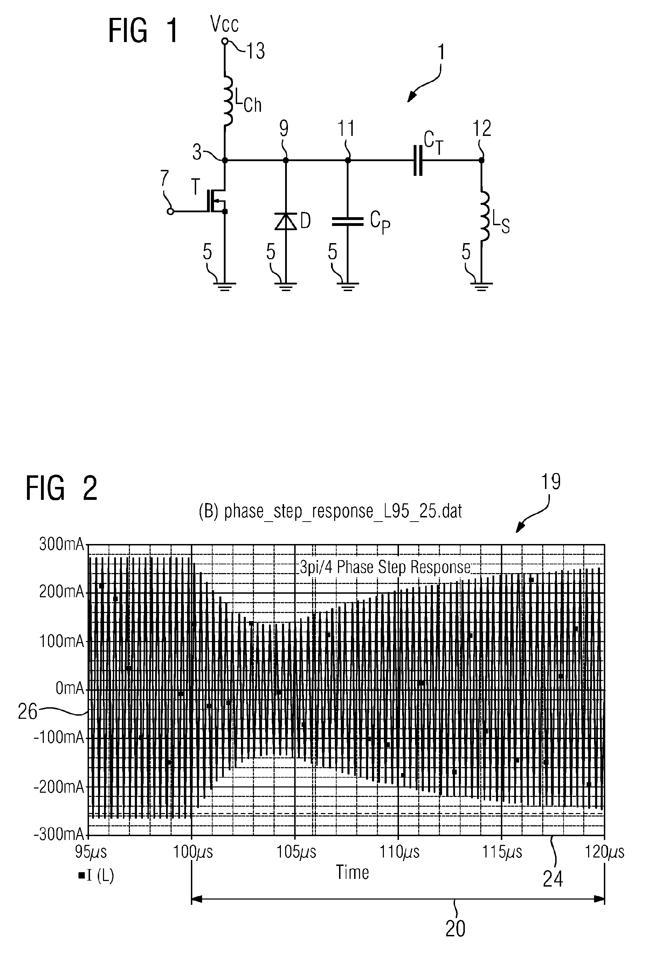

Figur 1 zeigt ein Ausführungsbeispiel für einen aus dem Stand der Technik bekannten Klasse-E-Verstärker mit einer Sendespule als Ausgangslast.

Der Verstärker 1 weist einen Anschluss 13 für eine Spannungsquelle zum Versorgen des Verstärkers 1 mit elektrischer Energie auf. Der Anschluss 13 ist mit einem ersten Anschluss einer Drosselspule L_Ch verbunden. Ein zweiter Anschluss der Drosselspule L_Ch des Verstärkers 1 ist mit einem Verbindungsknoten 3 verbunden. Der Verbindungsknoten 3 ist mit einem Drain-Anschluss eines Transistors T verbunden. Der Transistor T ist in dieser Ausführungsform als FeldeffektTransistor ausgebildet, wobei alternativ dazu auch ein bipolarer Transistor vorgesehen sein kann.

Der Transistor T ist mit einem Source-Anschluss mit einem Masseanschluss 5 verbunden. Ein Gate-Anschluss des Transistors T ist mit einem Eingang 7 des Verstärkers 1 für ein Steuersignal verbunden. Der Verbindungsknoten 3 ist über eine Verbindungsleitung mit einem Verbindungsknoten 9 verbunden. Der Verbindungsknoten 9 ist mit einem Katodenanschluss einer Diode D verbunden. Ein Anodenanschluss der Diode D ist mit dem Masseanschluss 5 verbunden.

Der Verstärker 1 weist auch einen Kondensator C_p auf, welcher als eine Parallelkapazität parallel zu einer Schaltstrecke des Transistors T geschaltet ist. Die Schaltstrecke ist zwischen dem Source-Anschluss und dem Drain-Anschluss des Transistors T gebildet.

Die Diode D und der Kondensator C_p sind jeweils zur Schaltstrecke des Transistors T parallel geschaltet.

Der Verstärker 1 weist auch einen Abstimm-Kondensator CT auf. Ein erster Anschluss des Abstimm-Kondensators CT ist mit dem Verbindungsknoten 11 verbunden. Ein zweiter Anschluss des Abstimm-Kondensators CT ist mit einem Verbindungsknoten 12 verbunden. Der Verbindungsknoten 12 ist mit einem ersten Anschluss einer Sendespule L_S verbunden. Ein zweiter Anschluss der Sendespule L_S ist mit dem Masseanschluss 5 verbunden.

Der Abstimm-Kondensator CT ist somit seriell über die Sendespule L_S mittelbar mit dem Masseanschluss 5 verbunden.

Die Drosselspule L_Ch ist in diesem Ausführungsbeispiel derart dimensioniert, dass sie für Schaltfrequenzen, für welche der Verstärker 1 vorgesehen ist, sperrend wirkt. Auf diese Weise kann eine über den Transistor T fließende Leistung über den Verbindungsknoten 3, den Verbindungsknoten 9, den Verbindungsknoten 11, den Abstimm-Kondensator CT, in den Verbindungsknoten 12 zur Sendespule L_S fließen und dort in ein Magnetfeld umgesetzt und/oder abgestrahlt werden.

Die Diode D erfüllt eine Funktion als Freilaufdiode und ist im Betrieb des Transistors T sperrend geschaltet. Die Diode D kann jedoch beim Ein- oder Ausschalten erzeugte Überspannungen durch die Drosselspule kurzschließen und so die Schaltstrecke des Transistors T wirksam vor Überspannungen schützen.

Figur 2 zeigt ein Diagramm 19. Das Diagramm 19 zeigt eine Kurve, welche einen Strom durch eine Sendespule des in Figur 1 dargestellten Verstärkers in Abhängigkeit von einer Zeit repräsentiert. Auf eine Abszisse 24 ist ein Zeitverlauf, in diesem Ausführungsbeispiel in Mikrosekunden aufgetragen. Auf eine Ordinate 26 des Diagramms 19 ist ein Strom durch die Sendespule L_S aufgetragen. Deutlich sichtbar ist ein Abfall des Stromes durch die Sendespule in einem Zeitabschnitt 20. Ein Zeitpunkt 100 µs auf der Abszisse 24 repräsentiert einen Phasenwechsel. Die Antwort des Verstärkers 1 auf diesen Phasenwechsel ist deutlich sichtbar als ein Bruch in der Ausgangsleistung des Verstärkers zu sehen, da beginnend mit dem Phasenwechsel zum Zeitpunkt 21 der Strom durch die Sendespule L_S während des Zeitabschnitts 20 deutlich reduziert ist und sich nur langsam erholt.

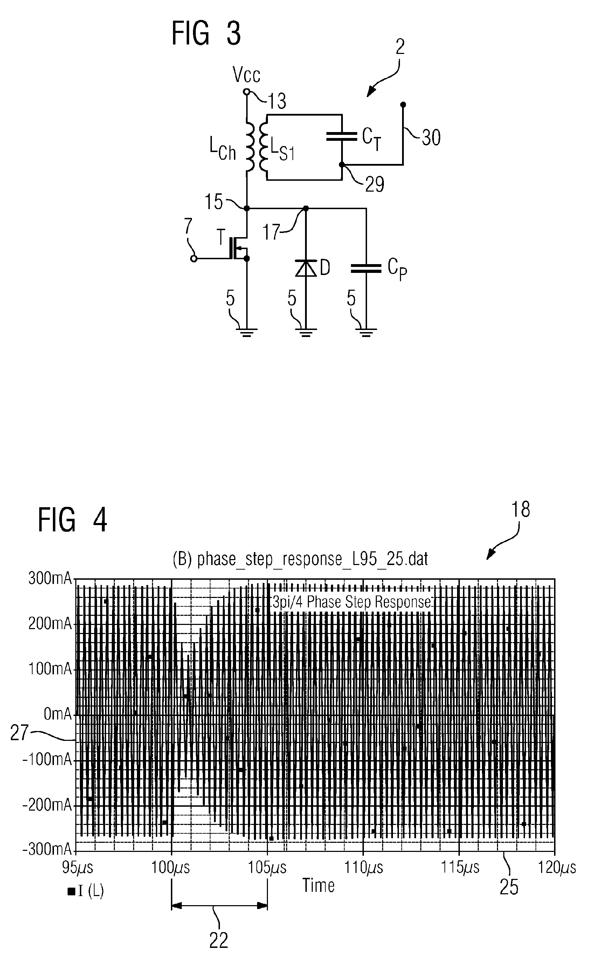

Figur 3 zeigt einen Verstärker 2, welcher als Klasse-E-Verstärker ausgebildet ist. Anders als bei dem in Figur 1 dargestellten Verstärker weist der in Figur 3 dargestellte Verstärker 2 eine Sendespule L_S1 auf, welche gemeinsam mit einer Drosselspule L_Ch des Verstärkers 2 transformatorisch gekoppelt ist. Der Verstärker 2 weist einen Anschluss 13 für eine Versorgungsspannungsquelle auf. Der Anschluss 13 ist mit einem ersten Anschluss der Drosselspule L_Ch verbunden. Ein zweiter Anschluss der Drosselspule L_Ch ist mit einem Verbindungsknoten 15 verbunden.

Der Verstärker 2 weist auch einen Transistor T auf. Der Transistor T ist in diesem Ausführungsbeispiel als FeldeffektTransistor ausgebildet. Denkbar sind jedoch auch andere Ausführungsformen für einen Transistor, insbesondere ein MOS-Feldeffekt-Transistor (MOS = Metal Oxide Semiconductor) oder eine bipolarer Transistor. Der Transistor T weist einen Source-Anschluss und einen Drain-Anschluss auf. Der Transistor T weist auch einen Gate-Anschluss auf. Der Transistor T ist ausgebildet, eine Schaltstrecke des Transistors T, gebildet zwischen dem Source-Anschluss und dem Drain-Anschluss in Abhängigkeit eines an dem Gate-Anschluss anliegenden Potentials durchzuschalten oder zu sperren. Der Source-Anschluss des Transistors T ist mit einem Masseanschluss 5 verbunden. Der Drain-Anschluss des Transistors T ist mit dem Verbindungsknoten 15 verbunden. Der Gate-Anschluss des Transistors T bildet einen Steuereingang 7 für den Verstärker 2.

Der Verbindungsknoten 15 ist über eine Verbindungsleitung mit einem Verbindungsknoten 17 verbunden. Der Verstärker 2 weist auch eine Diode D auf, welche anlog zu der in Figur 1 dargestellten Diode als Freilaufdiode zum Schützen der Schaltstrecke des Transistors T dienen kann.

Ein Katodenanschluss der Diode D ist mit dem Verbindungsknoten 17 verbunden und ein Anodenanschluss der Diode D ist mit dem Masseanschluss 5 verbunden.

Eine Parallelkapazität, gebildet durch einen Kondensator Cp ist zu der Diode D derart parallel geschaltet, dass ein erster Anschluss des Kondensators Cp mit dem Verbindungsknoten 17 und ein zweiter Anschluss des Kondensators Cp mit dem Masseanschluss 5 verbunden ist.

In dieser Ausführungsform des Verstärkers 2 ist die Drosselspule L_Ch bei einer zum Schalten des Transistors T vorgesehenen Schaltfrequenz wenigstens teilweise leitend ausgebildet. Auf diese Weise kann eine elektrische Energie in der Drosselspule L_Ch in ein Magnetfeld umgesetzt werden und transformatorisch in die Sendespule L_S1 eingekoppelt werden. Die Sendespule L_S1 ist zu einer Abstimm-Kapazität, gebildet durch einen Kondensator CT parallel geschaltet und bildet somit gemeinsam mit der Abstimm-Kapazität einen Schwingkreis. Der Schwingkreis weist eine Anzapfung 29 auf, welche in diesem Ausführungsbeispiel zwischen einem Anschluss des Abstimm-Kondensators CT und einem Anschluss der Sendespule L_S1 angeordnet ist.

Eine Sendeleistung eines durch die Sendespule L_S1 erzeugten Sendesignals ist durch ein Windungsverhältnis, gebildet aus Windungszahl von Sendespulenwindungen und Windungszahl von Drosselspulenwindungen vorbestimmt.

Die Anzapfung 29 ist mit einer Antenne 30 verbunden. Eine in die Sendespule L_S1 eingekoppelte Sendeenergie kann somit wirksam über die Antenne 30 abgestrahlt werden. In einer anderen Ausführungsform kann ein zum Übertragen von Daten vorgesehener Verstärker 2 ist keine Antenne 30 aufweisen. Ein solcher Verstärker kann dazu vorgesehen sein, mittels der Sendespule L_S1 mittels transformatorischen Koppelns ein Sendesignal an eine entsprechend angeordnete Empfangsspule zu übertragen.

Figur 4 zeigt ein Diagramm 18. Das Diagramm 18 zeigt eine Kurve, welche einen Strom durch die in Figur 3 dargestellte Sendespule L_S1 des Verstärkers 2 in Abhängigkeit von einer Zeit repräsentiert.

Das Diagramm 18 weist eine Abszisse 25 auf, welche einen Zeitverlauf repräsentiert. Das Diagramm weist auch eine Ordinate 27 auf, welche einen Strom durch die Sendespule L_S1 des Verstärkers 2 repräsentiert.

Ein Zeitabschnitt 22 auf der Abszisse 25 zeigt ein Einbrechen eines Stromes durch die Sendespule L_S1 verursacht durch einen Phasenwechsel zum Zeitpunkt 100 µs. Deutlich sichtbar ist ein schnelles Erholen eines Stromes durch die Sendespule L_S1, insbesondere im Vergleich zu dem in Figur 2 dargestellten zeitabhängigen Stromverlauf. Die Zeit, nachdem ein Strom durch eine Sendespule, verursacht durch einen Phasenwechsel nach einem durch den Phasenwechsel verursachten Einbruch über einen ursprünglichen Wert annimmt, beträgt bei dem in Figur 1 dargestellten Verstärker 1 gemäß dem Zeitabschnitt 20 in Figur 2 20 µs, wohingegen eine so gebildete Erholungszeit, repräsentiert durch einen Zeitabschnitt 22 in Diagramm 18 nur 5 µs beträgt.

Der in Figur 3 dargestellte Verstärker 2 ermöglicht somit aufgrund der transformatorischen Ankopplung der Sendespule L_ S1 an die Drosselspule L_Ch einen vierfach schnelleren Phasenwechsel als der in Figur 1 dargestellte Verstärker 1.

## Patentansprüche

1. Verstärker, nämlich ein Klasse-E-Verstärker (2) für ein Radiofrequenzsignal zum Übertragen eines Sendesignals an eine otologische Vorrichtung,
wobei der Verstärker (2) wenigstens einen Leistungstransistor (T) zum Schalten eines Ausgangssignals aufweist, und wobei eine Schaltstrecke des Leistungstransistors (T) mit einem Netzwerk (Cp, L_Ch) derart wirkverbunden ist, dass eine im Leistungstransistor umgesetzte Verlustleistung mindestens während eines Umschaltens in einen durchgeschalteten Zustand und/oder mindestens während eines Umschaltens in einen gesperrten Zustand wenigstens teilweise reduziert ist,
und wobei die Schaltstrecke des wenigstens einen Transistors in Serie über eine Drosselspule (L_Ch) mindestens mittelbar mit einer Versorgungsspannungsquelle (13) verbunden ist,
wobei eine Sendespule (L_S1) als Ausgangslast mit der Schaltstrecke des Leistungstransistors (T) in Serie geschaltet ist und wobei die Sendespule (L_S1) eine Induktivität aufweist,
**dadurch gekennzeichnet,**
**dass** die Sendespule (L_S1) mit der Drosselspule transformatorisch gekoppelt ist und die Drosselspule (L_Ch) so eine Ausgangsleistung auf die Sendespule (L_S1) übertragen kann.

2. Verstärker nach Anspruch 1,
**dadurch gekennzeichnet,**
**dass** die Sendespule (L_S1) von dem Verstärker galvanisch getrennt ist.

3. Verstärker nach Anspruch 1,
**dadurch gekennzeichnet,**
**dass** die Sendespule (L_S1) mit einer Abstimmimpedanz (C_T) wirkverbunden ist.

4. Verstärker nach Anspruch 3,
**dadurch gekennzeichnet,**
**dass** die Abstimmimpedanz (C_T) einen Kondensator und/oder einen Ohmschen Widerstand aufweist.

5. Verstärker nach einem der vorhergehenden Ansprüche,
**dadurch gekennzeichnet,**
**dass** die Ausgangsleistung des Radiofrequenz-Verstärkers wenigstens teilweise durch ein Windungsverhältnis bestimmt ist, gebildet aus einer Windungsanzahl von Windungen der Drosselspule und aus einer Windungsanzahl von Windungen der Sendespule.

6. Verstärker nach einem der vorhergehenden Ansprüche,
**dadurch gekennzeichnet,**
**dass** die Drosselspule (L_Ch) zusätzlich mit einem Ohmschen Vorwiderstand in Serie geschaltet ist und so eine Ausgangsleistung des Verstärkers wenigstens teilweise von dem Vorwiderstand Abhängig ist.

7. Verstärker nach einem der vorhergehenden Ansprüche,
**dadurch gekennzeichnet, dass**
der Verstärker dazu vorgesehen ist, mittels der Sendespule mittels transformatorischen Koppelns das Sendesignal an eine entsprechend angeordnete Empfangsspule zu übertragen.

8. Verstärker nach einem der vorhergehenden Ansprüche,
**dadurch gekennzeichnet,**
**dass** zu der Sendespule eine Abstimm-Kapazität parallelgeschaltet ist und so gemeinsam mit der Abstimm-Kapazität einen Schwingkreis bildet, wobei der Schwingkreis eine Anzapfung aufweist, welche mit einer Antenne verbunden ist.

9. Verstärker nach einem der vorhergehenden Ansprüche,
**dadurch gekennzeichnet,**
**dass** der Verstärker (2) ein Sendeverstärker eines Radiofrequenzsenders einer otologischen Vorrichtung ist.

10. Verstärker nach einem der vorhergehenden Ansprüche,
**dadurch gekennzeichnet,**
**dass** der Verstärker ein Sendeverstärker eines Radiofrequenzsenders für eine Programmiervorrichtung zum Programmieren einer otologischen Vorrichtung ist.
